(19) Europäisches Patentamt

European Patent Office

Office européen des brevets

(11) EP 0 436 222 B1

## (12) FASCICULE DE BREVET EUROPEEN

(45) Date de publication et mention
de la délivrance du brevet:
**24.01.1996 Bulletin 1996/04**

(51) Int Cl.6: **H03M 1/18**, H03D 3/00,
G01R 29/06

(21) Numéro de dépôt: **90125595.0**

(22) Date de dépôt: **27.12.1990**

(54) **Circuit de mesure numérique d'un signal électrique**

Schaltung zur digitalen Messung eines elektrischen Signals

Circuit for the digital measurement of an electrical signal

(84) Etats contractants désignés:
**AT BE CH DE DK ES FR GB GR IT LI LU NL SE**

(30) Priorité: **05.01.1990 FR 9000088**

(43) Date de publication de la demande:
**10.07.1991 Bulletin 1991/28**

(73) Titulaire:
**ALCATEL MOBILE COMMUNICATION FRANCE
F-75008 Paris (FR)**

(72) Inventeurs:
- **Trinh van, Christian
  F-91800 Brunoy (FR)**
- **Desperben, Lydie
  F-92270 Bois Colombes (FR)**

(74) Mandataire: **Weinmiller, Jürgen et al
D-82336 Feldafing (DE)**

(56) Documents cités:
**EP-A- 0 072 144        FR-A- 2 234 709
US-A- 4 383 247**

# Description

La présente invention concerne un circuit de mesure qui donne la valeur numérique d'un signal électrique.

Le signal électrique dont il faut faire la mesure est un signal analogique susceptible de prendre différentes valeurs entre une valeur maximale et une valeur minimale. Le rapport de ces dernières définit la dynamique de ce signal. Il est ainsi connu d'utiliser, pour obtenir une mesure numérique d'un tel signal, un convertisseur analogique-numérique dont la dynamique propre est supérieure à celle du signal. La dynamique d'un convertisseur, se définissant comme celle d'un signal, correspond au plus grand nombre qu'il peut générer, le plus petit nombre étant égal à l'unité. Elle est ainsi fonction du nombre de bits de ce convertisseur.

Lorsque le signal a une dynamique relativement faible, correspondant à un convertisseur 8 bits par exemple, cette solution est bien adaptée car les convertisseurs de ce type sont courants et économiques. Si, par contre, le signal a une dynamique plus importante, l'emploi d'un convertisseur ayant une dynamique plus étendue, 12 bits par exemple, s'avère très coûteux.

Cette solution n'étant pas avantageuse, une autre solution, décrite notamment dans le brevet US-A-4 383 247, a été développée qui consiste à utiliser un amplificateur à gain variable recevant le signal électrique pour le transmettre à un convertisseur analogique-numérique de dynamique réduite, la donnée numérique issue de ce convertisseur déterminant la valeur du gain. La commande du gain se fait donc dans une boucle d'asservissement et un tel dispositif est soumis aux limitations connues inhérentes aux systèmes asservis.

La présente invention a ainsi pour objet un circuit de mesure qui donne la valeur numérique d'un signal électrique comprenant un amplificateur à gain variable et un convertisseur analogique numérique, ce circuit ne faisant pas appel à une boucle d'asservissement.

Le circuit de mesure numérique d'un signal électrique analogique selon l'invention produit un signal de mesure et comprend un amplificateur recevant ce signal électrique et dont le gain est commandé par un signal de commande, comprend également, à la suite de cet amplificateur, un convertisseur analogique-numérique au moins délivrant une donnée numérique et une unité de commande pour produire ce signal de commande afin que le gain puisse prendre deux valeurs au moins, et se caractérise en ce que cette unité de commande produit durant un cycle de mesure ce signal de commande successivement dans ses deux états au moins, mémorise les valeurs de la donnée numérique corespondant aux deux états et comprend des moyens pour produire le signal de mesure à partir des valeurs de la donnée numérique.

De plus, dans le circuit de mesure numérique d'un signal électrique analogique le signal de mesure est calculé à partir des valeurs moyennes des données numériques (N) associées aux deux valeurs au moins du gain.

Dans un mode de réalisation du circuit de mesure numérique d'un signal électrique, l'unité de commande conserve en mémoire un seuil de saturation, mémorise une valeur $N_1$ issue du convertisseur pour un gain $G_1$ de l'amplificateur, mémorise une valeur $N_2$ issue du convertisseur pour un gain $G_2$ de l'amplificateur, $G_1$ étant inférieur à $G_2$, et produit un signal de mesure qui vaut $N_1/G_1$ si $N_2$ est supérieur au seuil de saturation et $N_2/G_2$ dans le cas contraire.

Le circuit de mesure numérique d'un signal électrique analogique trouvera une application avantageuse dans la mesure d'un signal sinusoïdal modulé en phase ou en fréquence où l'unité de commande élabore la donnée numérique en prenant la racine carrée de la somme des carrés de deux valeurs numériques, ces valeurs numériques étant issues de deux convertisseurs analogique-numérique recevant chacun d'un démodulateur en quadrature un des deux signaux en bande de base, ce démodulateur recevant le signal sinusoïdal par l'intermédiaire de l'amplificateur.

Les différents objets et caractéristiques de l'invention ressortiront avec de plus amples détails dans la description d'exemples de réalisation donnés à titre non limitatif en se référant aux figures annexées qui représentent :

- la figure 1, un diagramme d'un premier mode de réalisation du circuit de mesure numérique d'un signal électrique analogique selon l'invention,
- la figure 2, un schéma d'application de ce circuit de mesure numérique.

Les éléments identiques présents dans les deux figures porteront une seule référence.

Bien que l'invention s'applique à un signal variable, l'hypothèse sera faite, dans un premier temps, que le signal garde une valeur constante pendant la durée de la mesure.

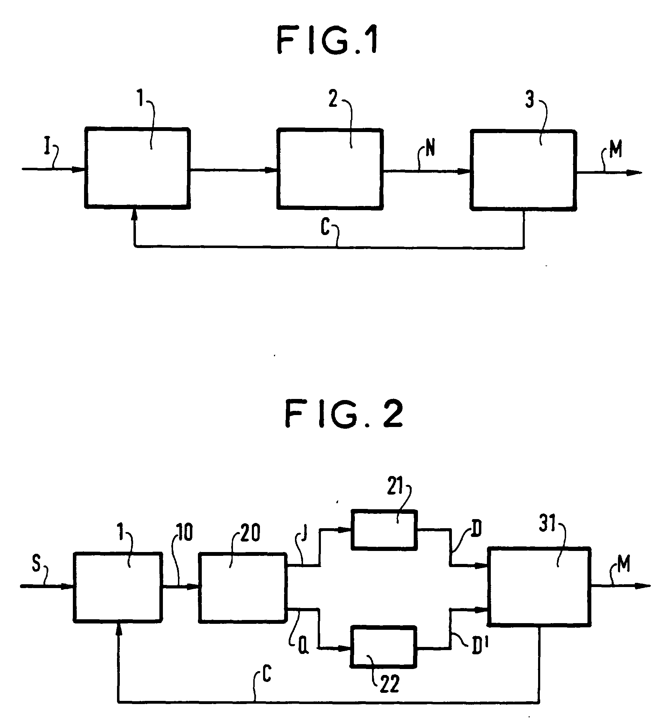

Le circuit de mesure numérique représenté dans la figure 1 reçoit un signal d'entrée analogique I et produit un signal de mesure M sous forme numérique. Il comprend essentiellement un amplificateur 1, suivi d'un convertisseur analogique-numérique 2 lui-même suivi d'une unité de commande 3.

Le signal d'entrée I évolue entre une valeur minimale $I_m$ et une valeur maximale $I_M$.

L'amplificateur 1 est un circuit dont on peut commander le gain de manière discrète par un signal de commande C. De tels circuits sont connus, ils sont constitués, par exemple, d'un amplificateur opérationnel et d'un réseau de résistances où l'on commute ces résistances de manière à faire varier le gain. Il peut également comprendre un amplificateur à gain fixe suivi ou précédé d'un atténuateur dont on fait varier l'atténuation. De plus, bien qu'il soit figuré en un seul module, cet amplificateur variable peut physiquement se décomposer en plusieurs éléments disposés le long d'une chaîne de mesure, chaque élément pouvant présenter un gain ou une atténuation variable. Dans le cas considéré, cet amplificateur 1 est unique et peut présenter deux valeurs de gain $G_1$ et $G_2$, $G_1$ étant inférieur à $G_2$.

Le convertisseur analogique-numérique 2 a une sensibilité S qui est le plus petit signal qu'il puisse détecter. Il a une dynamique D, c'est-à-dire qu'il peut différencier tous les signaux compris entre S et S.D. Il produit une valeur numérique N.

Les différentes valeurs numériques évoquées doivent satisfaire certaines relations compte-tenu de la spécification du signal d'entrée I :

$$- I_m \cdot G_2 \geq S$$

$$- I_M \cdot G_1 \leq S.D$$

L'unité de commande 3 produit un signal de mesure M numérique qui est la valeur du signal d'entrée I. L'intervalle de temps d'observation durant lequel la mesure est faite est divisé en quatre parties qui définissent un cycle de mesure :

- durant la première partie, l'unité de commande produit un signal de commande C qui impose à l'amplificateur 1 le gain $G_1$ ,
- ensuite, elle mémorise la valeur $N_1$ issue du convertisseur 2.
- durant la troisième partie elle commute le gain de l'amplificateur à la valeur $G_2$ par l'intermédiaire du signal de commande C,
- enfin, elle mémorise la valeur $N_2$ issue du convertisseur 2.

L'unité de commande comprend également en mémoire un seuil de saturation auquel est comparée la valeur $N_2$ . Si $N_2$ dépasse ce seuil la mesure est déclarée non valable et l'unité de commande produit un signal de mesure M qui vaut $N_1/G_1$ . Si tel n'est pas le cas, l'unité de commande fournit alors un signal de valeur $N_2/G_2$. Sans sortir du cadre de l'invention, l'unité de commande peut produire un signal de mesure de tout autre manière. Elle peut, par exemple, faire correspondre une seule valeur à tous les signaux d'entrée I compris entre deux valeurs déterminées.

Ainsi, en employant un convertisseur de 8 bits qui possède une dynamique de 48 dB, il est possible de mesurer un signal d'entrée d'une dynamique de 64 dB, ce qui nécessiterait normalement l'emploi d'un convertisseur 11 bits. Il est à noter que, dans cette configuration, le circuit de mesure numérique accepterait théoriquement un signal d'entrée d'une dynamique de 96 dB si l'écart entre $G_1$ et $G_2$ était de 48 dB. Cette configuration se généralisera facilement au cas où l'amplificateur 1 peut être commuté sur plus de deux gains. De même, l'emploi d'un convertisseur 8 bits n'est pas limitatif.

L'invention a été décrite en considérant que l'unité de commande 3 faisait une seule acquisition pour une valeur de gain donnée. La mesure peut être rendue plus fiable en multipliant ce nombre d'acquisitions pendant l'intervalle de temps d'observation en jouant sur la fréquence d'échantillonnage du convertisseur par exemple. L'unité de commande produit alors un résultat qui est une valeur moyenne.

Jusqu'à présent, le signal d'entrée I a été supposé constant pendant l'intervalle de temps d'observation. L'invention s'applique également si ce n'est pas le cas.

S'il s'agit, par exemple, de mesurer la valeur crête d'un signal périodique, ce signal sera injecté sur un circuit de détection de crête connu avant d'attaquer le circuit de mesure numérique.

L'invention s'applique de manière particulièrement avantageuse lorsqu'il est nécessaire de mesurer le niveau d'un signal sinusoïdal modulé en phase ou en fréquence.

Dans cette application, dont une représentation schématique est donnée à la figure 2, ce signal S est injecté sur un amplificateur 1 identique à celui précédemment décrit. Cet amplificateur est suivi d'un démodulateur en quadrature 20 recevant le signal S amplifié et produisant deux signaux en bande de base J, Q déphasés de $\pi/2$ vis-à-vis de la fréquence porteuse du signal S. Ces signaux J, Q sont respectivement injectés sur deux convertisseurs analogique-numérique 21, 22 identiques au convertisseur 2 de la figure 1 qui produisent les données numériques D, D'.

Une unité de commande 31 qui reçoit ces données numériques élabore la valeur numérique N précédemment définie en prenant la racine carrée de la somme des carrés de D et D', ce qui découle de la nature sinusoïdale du signal d'entrée. Le traitement numérique est ensuite effectué conformément à la procédure déjà décrite.

L'invention s'applique sous réserve que la fréquence de modulation soit largement inférieure à la fréquence porteuse. Il faut en effet considérer que le signal d'entrée S conserve la même phase pendant une durée équivalente à un quart de période de cette porteuse. L'erreur introduite par cette hypothèse sera beaucoup réduite si le signal de mesure M résulte de la moyenne d'un grand nombre d'acquisitions, ce que permet l'invention comme cela a été précisé.

## Revendications

1.  Circuit de mesure numérique d'un signal électrique analogique produisant un signal de mesure (M), comprenant un amplificateur (1) recevant ce signal électrique (I) et dont le gain est commandé par un signal de commande (C), comprenant également, à la suite dudit amplificateur, un convertisseur analogique-numérique (2) au moins qui délivre une donnée numérique (N) et une unité de commande (3) pour produire ledit signal de commande dans deux états au moins, afin que ledit gain puisse prendre deux valeurs au moins, caractérisé en ce que ladite unité de commande (3) produit durant un cycle de mesure ledit signal de commande successivement dans ses deux états au moins, mémorise les valeurs de ladite donnée numérique correspondant auxdits états et comprend des moyens pour produire ledit signal de mesure à partir desdites valeurs de la donnée numérique.

2. Circuit de mesure numérique d'un signal électrique analogique selon la revendication précédente, caractérisé en ce que ledit signal de mesure (M) est calculé à partir des valeurs moyennes desdites données numériques (N) associées aux deux valeurs au moins dudit gain.

3. Circuit de mesure numérique d'un signal électrique analogique selon l'une quelconque des revendications précédentes, caractérisé en ce que ladite unité de commande (3) conserve en mémoire un seuil de saturation, mémorise une valeur $N_1$ issue dudit convertisseur (2) pour un gain $G_1$ dudit amplificateur (1), mémorise une valeur $N_2$ issue dudit convertisseur (2) pour un gain $G_2$ dudit amplificateur (1), $G_1$ étant inférieur à $G_2$, et produit un signal de mesure (M) qui vaut $N_1/G_1$ si $N_2$ est supérieur audit seuil de saturation et $N_2/G_2$ dans le cas contraire.

4. Application du circuit de mesure numérique d'un signal électrique analogique selon l'une quelconque des revendications précédentes à la mesure d'un signal sinusoïdal (S) modulé en phase ou en fréquence, caractérisée en ce que ladite unité de commande (31) élabore ladite donnée numérique (N) en prenant la racine carrée de la somme des carrés de deux valeurs numériques (D, D'), lesdites valeurs numériques étant issues de deux dits convertisseurs analogique-numérique (21, 22) recevant chacun d'un démodulateur en quadrature (20) un des deux signaux en bande de base (J, Q), ce démodulateur recevant ledit signal sinusoïdal (S) par l'intermédiaire dudit amplificateur (1).

**Patentansprüche**

1. Schaltung zur digitalen Messung eines analogen elektrischen Signals, die ein Meßsignal (M) erzeugt und einen Verstärker (1) enthält, der dieses elektrische Signal (I) empfängt, und dessen Verstärkungsgrad von einem Steuersignal (C) gesteuert wird, und die weiter hinter diesem Verstärker einen Analog-Digital-Wandler (2), der mindestens eine digitale Größe (N) liefert, und eine Steuereinheit (3) aufweist, um dieses Steuersignal in mindestens zwei Zuständen zu erzeugen, damit der Verstärkungsgrad mindestens zwei Werte annehmen kann, dadurch gekennzeichnet, daß diese Steuereinheit (3) während eines Meßzyklus dieses Steuersignal nacheinander in seinen mindestens zwei Zuständen erzeugt und die Werte der den beiden Zuständen entsprechenden digitalen Größe speichert und daß Mittel vorgesehen sind, um das Meßsignal aus den Werten der digitalen Größe zu erzeugen.

2. Schaltung zur digitalen Messung eines analogen elektrischen Signals nach dem vorhergehenden Anspruch, dadurch gekennzeichnet, daß das Meßsignal (M) ausgehend von Mittelwerten der digitalen Daten (N) berechnet wird, die den mindestens zwei Werten des Verstärkungsgrades zugeordnet sind.

3. Schaltung zur digitalen Messung eines analogen elektrischen Signals nach einem beliebigen der vorhergehenden Ansprüche, dadurch gekennzeichnet, daß die Steuereinheit (3) eine Sättigungsschwelle im Speicher enthält und einen Wert $N_1$ aus dem Wandler (2) für einen Verstärkungsgrad $G_1$ des Verstärkers (1) sowie einen Wert $N_2$ aus dem Wandler (2) für einen Verstärkungsgrad $G_2$ des Verstärkers (1) speichert, wobei $G_1$ kleiner ist als $G_2$, und ein Meßsignal (M) erzeugt, das gleich $N_1/G_1$ ist, wenn $N_2$ höher ist als die Sättigungsschwelle, und gleich $N_2/G_2$ im gegenteiligen Fall.

4. Anwendung der Schaltung zur digitalen Messung eines analogen elektrischen Signals nach einem beliebigen der vorhergehenden Ansprüche auf die Messung eines sinusförmigen Signals (S), das phasen- oder frequenzmoduliert ist, dadurch gekennzeichnet, daß die Steuereinheit (31) die digitale Größe (N) ermittelt, indem sie die Quadratwurzel der Summe der Quadrate von zwei digitalen Werten (D, D') verwendet, die aus zwei Analog-Digital-Wandlern (21, 22) stammen, welche je von einem Demodulator (20) in Quadratur eines der beiden Signale (J, Q) im Basisband empfangen, wobei dieser Demodulator das sinusförmige Signal (S) über den Verstärker (1) zugeführt erhält.

**Claims**

1. A digital measurement circuit for measuring an analog electrical signal and producing a measurement signal (M), the measurement circuit comprising an amplifier (1) receiving the electrical signal (I) and having its gain controlled by a control signal (C), the amplifier being followed both by at least one analog-to-digital converter (2) which delivers digital data (N), and by a control unit (3) for producing said control signal which occupies at least two states, thereby enabling said gain to take at least two values, the measurement circuit being characterized in that during a measurement cycle said control unit (3) produces said control signal successively in its at least two states, stores the values of said digital data corresponding to said states, and includes means for producing said measurement signal on the basis of said stored digital data values.

2. A digital measurement circuit for measuring an analog electrical signal according to the preceding claim, the circuit being characterized in that said measurement signal (M) is calculated on the basis of average values of said digital data (N) associated with respective ones of said at least two gain values.

3. A digital measurement circuit for measuring an analog electrical signal according to either preceding claim, characterized in that said control unit (3) stores a saturation threshold, stores a value $N_1$ from said converter (2) for a gain $G_1$ of said amplifier (1), stores a value $N_2$ from said converter (2) for a gain $G_2$ of said amplifier (1), where $G_1$ is less than $G_2$, and produces a measurement signal (M) which is equal to $N_1/G_1$ if $N_2$ is greater than said saturation threshold, and which is otherwise equal to $N_2/G_2$.

4. An application of the digital measurement circuit for measuring an analog electrical signal according to any preceding claim to measuring a sinewave signal (S) which is modulated in phase or in frequency, characterized in that said control unit (31) generates said digital data (N) by taking the square root of the sum of the squares of two digital values (D, D'), said digital values being delivered by two of said analog-to-digital converters (21, 22) each receiving a respective one of two baseband signals (J, Q) from a quadrature demodulator (20), said demodulator receiving said sinewave signal (S) via said amplifier (1).

# FIG.1

# FIG. 2